# EUROPÄISCHE PATENTSCHRIFT

(11) **EP 2 856 649 B1**
(45) Veröffentlichungstag und Bekanntmachung des Hinweises auf die Patenterteilung: **14.02.2018**
(21) Anmeldenummer: 13724166.7
(22) Anmeldetag: 16.05.2013
(51) Int. Cl.: H03M 1/10, H03M 1/12

(54) **ANALOGSIGNAL-EINGANGSSCHALTUNG MIT EINER ANZAHL VON ANALOGSIGNAL-ERFASSUNGSKANÄLEN**
ANALOGUE SIGNAL INPUT CIRCUIT WITH A NUMBER OF ANALOGUE SIGNAL DETECTION CONDUITS
CIRCUIT D'ENTRÉE DE SIGNAUX ANALOGIQUES AVEC UN CERTAIN NOMBRE DE CANAUX DE DÉTECTION DE SIGNAUX ANALOGIQUES

(30) Priorität: 24.05.2012 DE 102012010143
(43) Veröffentlichungstag der Anmeldung: 08.04.2015
(73) Patentinhaber: Phoenix Contact GmbH & Co. KG, 32825 Blomberg (DE)
(72) Erfinder: OSTER, Viktor, 32825 Blomberg (DE); LOHRE, Hubertus, 32839 Steinheim (DE)
(74) Vertreter: Blumbach · Zinngrebe Patent- und Rechtsanwälte
(86) Internationale Anmeldenummer: PCT/EP2013/001443
(87) Internationale Veröffentlichungsnummer: WO 2013/174490

(56) Entgegenhaltungen:
- DE-A1-102005 011 406
- US-B1- 6 445 319
- US-B1- 7 227 479
- KENNETH C DYER ET AL: "An Analog Background Calibration Technique for Time-Interleaved Analog-to-Digital Converters", IEEE JOURNAL OF SOLID-STATE CIRCUITS, IEEE SERVICE CENTER, PISCATAWAY, NJ, USA, Bd. 33, Nr. 12, Dezember 1998 (1998-12), XP011060879, ISSN: 0018-9200

## Beschreibung

Die Verarbeitung von analogen Eingangsgrößen wie z.B. Temperatur oder Druck, ist besonders in der Prozessindustrie stark verbreitet. Viele dieser Signale dienen der Prozessüberwachung und sind daher häufig für die Sicherheit des Prozesses von entscheidender Relevanz.

Im Unterschied zu digitalen Signalen ist die Analogtechnik jedoch sehr aufwändig. Der einfachste Weg, Analogschaltungen auf ihre Funktion zu prüfen besteht z.B. darin, eine Referenzquelle an die Analogschaltung anzulegen und den gemessenen Wert mit dem Sollwert zu vergleichen.

Insbesondere die Anforderungen der Sicherheitsnorm DIN EN 91508 an die Diagnosedeckung für höhere Sicherheitsintegritätslevel (z.B. SIL2 oder SIL3) zum Zeitpunkt der vorliegenden Anmeldung sind jedoch weiterhin nur mit einem enormen Schaltungsaufwand möglich.

Insbesondere um derartigen höheren Sicherheitsintegritätsleveln zu genügen, sind aus dem Stand der Technik auch redundant ausgebildete Signalverarbeitungsstrukturen und diesbezügliche Diagnosezenarien bekannt, wobei beispielhaft die DE 10 2007 062 974 der selben Anmelderin, die DE 2 108 496 A, die EP 1 643 323 A1, die US 2005/240806 A1, die US 5,838,899, die US 4,358,823 die US 2002/0152420 A1, die US 2006/0010352 A1, die US 6,985,975, die EP 2 175 371, die EP 2 207 097, die EP 2 228 723, die EP 2 196 908, die US 7 949 833, die US 7 979 746 oder die US 8 037 364 genannt seien. Weitere standesgemäße Analogsignal-Eingangsschaltungen zur Verarbeitung von für die Sicherheit eines Prozesses relevanten analogen Eingangssignalen sind aus den Druckschriften DE 10 2005 011406 A1 und US 6 445 319 B1 bekannt.

In der Regel haben derartige redundant ausgebildete Signalverarbeitungsstrukturen und diesbezügliche Diagnosezenarien typischerweise als Nachteil, dass Testeinheiten die Signalverarbeitungsstrukturen sicherheitsrelevant beeinflussen können, dass ein Nachweis über die Rückwirkungsfreiheit mit sehr großen Aufwand verbunden ist, dass die Diagnosedeckung der Testeinheit eingeschränkt ist, Testimpulse einer Diagnoseeinheit oft nach außen sichtbar sind und den Prozess stören können und/oder, dass während des Testens die betroffenen Signalverarbeitungsstrukturen nur bedingt einsatzbereit sind bzw. die Sicherheitsfunktion für die Testzeit ausgeblendet werden muss.
Aufgabe der Erfindung ist es, eine flexible, geräteunabhängige und günstige Lösung zur Realisierung einer Analogsignal-Eingangsschaltung zur Verarbeitung von analogen Eingangssignalen, insbesondere von für die Sicherheit eines Prozesses relevanten analogen Eingangssignalen aufzuzeigen, welche einen hohen Sicherheitsintegritätslevel auch bei Diagnose- oder Testszenarien bereitstellt.
Die Erfindung löst diese Aufgabe durch die Merkmale der unabhängigen Patentansprüche. Zweckmäßige Ausgestaltungen und Weiterbildungen sind Gegenstand der abhängigen Ansprüche.

Dementsprechend sieht eine Lösung der Erfindung eine Analogsignal-Eingangsschaltung mit einer ersten Anzahl von Analogsignal-Erfassungskanälen und zumindest einer Diagnoseschaltung vor, wobei jeder Analogsignal-Erfassungskanal ausgebildet ist, ein an einem analogen Signaleingang aus einer zweiten Anzahl von analogen Signaleingängen anliegendes analoges Eingangssignal zu erfassen und ansprechend auf ein erfasstes analoges Eingangssignal ein Ausgangssignal auszugeben. Jeder Analogsignal-Erfassungskanal beherbergt jeweils zwei Analogsignal-Erfassungsschaltungen und zumindest eine erste Verbindungsauswahlvorrichtung und jede Analogsignal-Erfassungsschaltung eine erste Anschlusseinrichtung und eine zweite Anschlusseinrichtung. Jede der Analogsignal-Erfassungsschaltungen eines Analogsignal-Erfassungskanals ist mit deren erster Anschlusseinrichtung mit demselben analogen Signaleingang aus der Anzahl von analogen Signaleingängen zur Erfassung eines analogen Eingangssignals zumindest zeitlich nacheinander verbindbar und beide Analogsignal-Erfassungsschaltungen eines Analogsignal-Erfassungskanals sind ausgebildet, ansprechend auf erfasste, einander entsprechende analoge Eingangssignale an deren zweiten Anschlusseinrichtungen einander einsprechende Ausgangssignale auszugeben. Je Analogsignal-Erfassungskanal ist für die Erfassung des an einem analogen Signaleingang aus der Anzahl von analogen Signaleingängen anliegenden analogen Eingangssignals und für die auf das erfasste analoge Eingangssignal ansprechende Ausgabe des Ausgangssignals jeweils eine der zwei beherbergten Analogsignal-Erfassungsschaltungen für einen bestimmbaren Zeitraum wechselnd ausgewählt, nicht mit deren erster Anschlusseinrichtung mit diesem analogen Signaleingang zur Erfassung dieses analogen Eingangssignals verbunden sondern für Test- und/oder Diagnosezwecke verwendet zu werden und die jeweils andere der zwei beherbergten Analogsignal-Erfassungsschaltungen ist für diesen bestimmbaren Zeitraum ausgewählt, mit deren erster Anschlusseinrichtung mit diesem analogen Signaleingang zur Erfassung dieses analogen Eingangssignals verbunden zu werden und ansprechend auf das erfasste analoge Eingangssignal an deren zweiter Anschlusseinrichtung als Ausgangssignal das Ausgangssignal des Analogsignal-Erfassungskanals auszugeben. Die erste Verbindungsauswahlvorrichtung ist hierzu ausgebildet, die jeweilige erste Anschlusseinrichtung der zwei beherbergten Analogsignal-Erfassungsschaltungen ansprechend auf die Auswahl zumindest entweder mit diesem zu verbindenden analogen Signaleingang oder mit der Diagnoseschaltung zu verbinden.

Ein wesentlicher Vorteil hierbei ist, dass die Analogsignal-Erfassungsschaltungen je Analogsignal-Erfassungskanal und je nach Bedarf für einen bestimmbaren Zeitraum zumindest mittels der Diagnoseschaltung Test- und/oder Diagnosezwecken unterworfen werden können, ohne dass hierbei eine einem Test und/oder einer Diagnose zu unterwerfende Analogsignal-Erfassungsschaltungen während der Diagnose innerhalb der Verarbeitungskette des Analogsignal-Erfassungskanals zur Erfassung von, von dem Analogsignal-Erfassungskanal zu verarbeitenden analogen Eingangssignalen vorgesehen ist, und also auch nicht in einer Sicherheitskette eines unter Nutzung des Analogsignal-Erfassungskanals zu steuernden Prozesses. Es können somit auch Überprüfungen vorgenommen werden, die bei der Verarbeitung durch den Analogsignal-Erfassungskanal, und folglich auch im Betrieb einer den Analogsignal-Erfassungskanal umfassenden Sicherheitskette nicht zulässig wären. Ferner können während der Diagnose auch an den Signaleingängen keine sichtbaren Diagnosesignale anliegen. Jegliche Diagnose beeinträchtigt folglich die vollständige hundertprozentige Funktion des Analogsignal-Erfassungskanals nicht. Die Erfindung ermöglicht somit insbesondere in Hinblick auf die Anforderungen in der Prozessindustrie eine hohe Verfügbarkeit.

Die erste Verbindungsauswahlvorrichtung kann hierbei Analogschalteinheiten umfassen, wobei in jeder Analogsignal-Erfassungsschaltung zweckmäßig jeweils eine Analogschalteinheit beherbergt ist.

Besitzt die erfindungsgemäße Analogsignal-Eingangsschaltung aufgrund höherer Sicherheitsintegritätslevel eine Anzahl von wenigsten zwei Analogsignal-Erfassungskanälen, die z.B. auch redundant betrieben werden können oder zu einem Redundanzblock zusammenschaltbar sind, ergibt sich darüber hinaus der Vorteil, dass lediglich stets die selben Analogsignal-Erfassungsschaltungen gegenseitig ausgetauscht sind und also stets eine dieser beiden in die Verarbeitungskette des selben Analogsignal-Erfassungskanal eingebunden ist, während stets die andere zu Diagnosezwecken mit der derselben Diagnoseschaltung verbunden sein kann. Da für die Analogsignal-Erfassungsschaltungen, den Analogsignal-Erfassungskanal und die Diagnoseschaltung folglich stets die gleichen Umgebungsbedingungen in Bezug auf jeweils angeschaltete bzw. eingebundene Verarbeitungskomponenten gewährleistet werden können, können mögliche Signalabweichungen zwischen den beiden Analogsignal-Erfassungsschaltungen oder auch Fehler innerhalb einer Analogsignal-Erfassungsschaltung somit wesentlich einfacher diagnostiziert werden.

Der Erfindung liegt folglich die Erkenntnis zugrunde, dass bei der Verarbeitung von analogen Eingangsgrößen, wie z.B. Temperatur oder Druck, entsprechenden analogen Eingangsignalen, insbesondere in der Prozessindustrie und insbesondere im Falle von analogen Eingangsignalen, die für die Sicherheit eines Prozesses von entscheidender Relevanz sind, die Funktionalität eines Analogsignal-Erfassungskanals einer Analogsignal-Eingangsschaltung, und folglich auch der sichere Betrieb einer den Analogsignal-Erfassungskanals umfassenden Sicherheitskette nicht nur nicht beeinträchtigt wird sondern darüber hinaus parallel deren hundertprozentige Funktion nahe zu vollständig überwacht werden kann, wenn jeweils zwei Analogsignal-Erfassungsschaltungen in einem Analogsignal-Erfassungskanal vorgesehen sind, von denen eine für die hundertprozentige Funktionalität des Analogsignal-Erfassungskanals überzählig ist und somit jeweils eine Analogsignal-Erfassungsschaltung einer solchen Analogsignal-Eingangschaltung für diverse Diagnosezwecken sowie zum Austausch der jeweilig anderen Analogsignal-Erfassungsschaltung zur Verfügung steht, so dass diese daraufhin für diverse Diagnosezwecken zur Verfügung steht.

Das erfindungsgemäße Konzept basiert somit ferner darauf, innerhalb jedem Analogsignal-Erfassungskanal eine zumindest zweifache Redundanz von sicherheitsrelevanten Elementen bereitzustellen, obgleich die Funktionalität eines jeden einzelnen Analogsignal-Erfassungskanals keine zwingende redundante Verarbeitung vorsieht, sondern gegebenenfalls erst zwei oder mehr Analogsignal-Erfassungskanäle redundant betrieben werden können oder zu einem Redundanzblock zusammenschaltbar sind.

Es sei darauf hingewiesen, dass auch eine Anzahl von einem analogen Signaleingang oder auch von mehr als zwei analogen Signaleingängen von der Formulierung "eine Anzahl von analogen Signaleingängen" bzw. "eine zweite Anzahl von analogen Signaleingängen" in den Ansprüchen sowie der Beschreibung umfasst sein soll, so dass die Anzahl zumindest 1 ist und ansonsten im wesentlichen beliebig groß sein kann.

So sieht eine weitere, insbesondere zur Erfassung schnellerer bzw. zeitkritischer analoger Eingangssignale, bevorzugte Lösung der Erfindung vor, dass jeder Analogsignal-Erfassungskanal ausgebildet ist, an einer zweiten Anzahl von wenigstens zwei analogen Signaleingängen anliegende analoge Eingangssignale zu erfassen und ansprechend auf erfasste analoge Eingangssignale Ausgangssignale auszugeben, wobei jeder Analogsignal-Erfassungskanal jeweils eine dritte Anzahl von Analogsignal-Erfassungsschaltungen beherbergt, und wobei die dritte Anzahl wenigstens drei beträgt und maximal um eins größer als die zweite Anzahl ist. Auch hierbei ist jede der Analogsignal-Erfassungsschaltungen eines Analogsignal-Erfassungskanals mit deren erster Anschlusseinrichtung mit jeweils einem analogen Signaleingang aus der zweiten Anzahl von analogen Signaleingängen zur Erfassung eines analogen Eingangssignals verbindbar und ansonsten entsprechend zur ersten Lösung ausgebildet. Für die Erfassung von an Signaleingängen aus der zweiten Anzahl von analogen Signaleingängen anliegenden analogen Eingangssignalen und für die auf die erfassten analogen Eingangssignale ansprechenden Ausgaben der Ausgangssignale ist hierbei je Analogsignal-Erfassungskanal jeweils eine Analogsignal-Erfassungsschaltung für einen bestimmbaren Zeitraum wechselnd ausgewählt, nicht mit deren erster Anschlusseinrichtung mit einem analogen Signaleingang zur Erfassung eines analogen Eingangssignals verbunden sondern für Test- und/oder Diagnosezwecke verwendet zu werden, und alle bis auf diese eine der dritten Anzahl von beherbergten Analogsignal-Erfassungsschaltungen sind jeweils für diesen bestimmten Zeitraum ausgewählt, mit deren ersten Anschlusseinrichtungen mit bestimmten analogen Signaleingängen aus der zweiten Anzahl von analogen Signaleingängen zur Erfassung von analogen Eingangssignalen verbunden zu werden und ansprechend auf die erfassten analogen Eingangssignale an deren zweiten Anschlusseinrichtungen als Ausgangssignale die Ausgangssignale des Analogsignal-Erfassungskanals auszugeben. Die erste Verbindungsauswahlvorrichtung ist folglich wiederum ausgebildet, die jeweiligen ersten Anschlusseinrichtungen aller beherbergten Analogsignal-Erfassungsschaltungen ansprechend auf die Auswahl zumindest entweder mit einem bestimmten zu verbindenden analogen Signaleingang oder mit der Diagnoseschaltung zu verbinden.

Besonders zweckmäßige Ausgestaltungen sehen vor, dass zumindest ein Analogsignal-Erfassungskanal zur Verarbeitung auch von digitalen Signalen ausgebildet ist und jede Analogsignal-Erfassungsschaltung dieses Analogsignal-Erfassungskanals einen Analog/Digital-Wandler beherbergt, dessen digitaler Signalanschluss an die jeweilige zweite Anschlusseinrichtung geschaltet ist und dessen analoger Signalanschluss zur ersten Verbindungsauswahleinrichtung geschaltet ist.

Besonders zweckmäßige Ausgestaltungen sehen ergänzend oder alternativ ferner vor, dass jeder Analogsignal-Erfassungskanal eine zweite Verbindungsauswahlvorrichtung besitzt, welche ausgebildet ist, in Abstimmung mit der ersten Verbindungsauswahlvorrichtung die zweiten Anschlusseinrichtungen entsprechend ausgewählt mit einer für die weitere Verarbeitung des Ausgangssignals des Analogsignal-Erfassungskanals vorgesehenen Verarbeitungsvorrichtung oder mit der Diagnoseschaltung zu verbinden.

Besonders zweckmäßige Ausgestaltungen sehen ergänzend oder alternativ ferner vor, dass die erste Verbindungsauswahlvorrichtung derart ausgebildet ist, so dass eine Verbindung einer jeweiligen ersten Anschlusseinrichtung mit einem bestimmten zu verbindenden analogen Signaleingang, mit der Diagnoseschaltung, mit wenigstens einer Referenzspannung oder mit wenigstens einer Versorgungsspannung eines Peripherieeinrichtung auswählbar ist.

Besonders zweckmäßige Ausgestaltungen sehen ergänzend oder alternativ ferner vor, dass die Analogsignal-Erfassungsschaltung eine aktive Signalanpassungseinrichtung beherbergt und/oder der ersten Anschlusseinrichtung eine Entkopplungsschaltung zugeordnet ist und/oder, dass zumindest ein analoger Signaleingang zusätzlich zu einer Eingangsklemme eine Eingangsschutzschaltung und/oder eine passive Signalanpassungseinheit besitzt.

Weitere Merkmale und Vorteile der Erfindung ergeben sich aus der nachfolgenden Beschreibung bevorzugter Ausführungsformen anhand der beigefügten Zeichnungen. In den Zeichnungen zeigen:
- Fig. 1: eine erste bevorzugte und besonders zweckmäßige Ausgestaltungen aufweisende Ausführungsform einer Analogsignal-Eingangsschaltung mit lediglich einem Analogsignal-Erfassungskanal,
- Fig. 2: eine weitere bevorzugte und besonders zweckmäßige Ausgestaltungen aufweisende Ausführungsform einer Analogsignal-Eingangsschaltung mit zwei Analogsignal-Erfassungskanälen, und
- Fig. 3: eine Skizze einer weiteren auf Fig. 1 basierenden Ausführungsform einer Analogsignal-Eingangsschaltung mit lediglich einem Analogsignal-Erfassungskanal, jedoch insbesondere zur Erfassung schnellerer bzw. zeitkritischer analoger Eingangssignale.

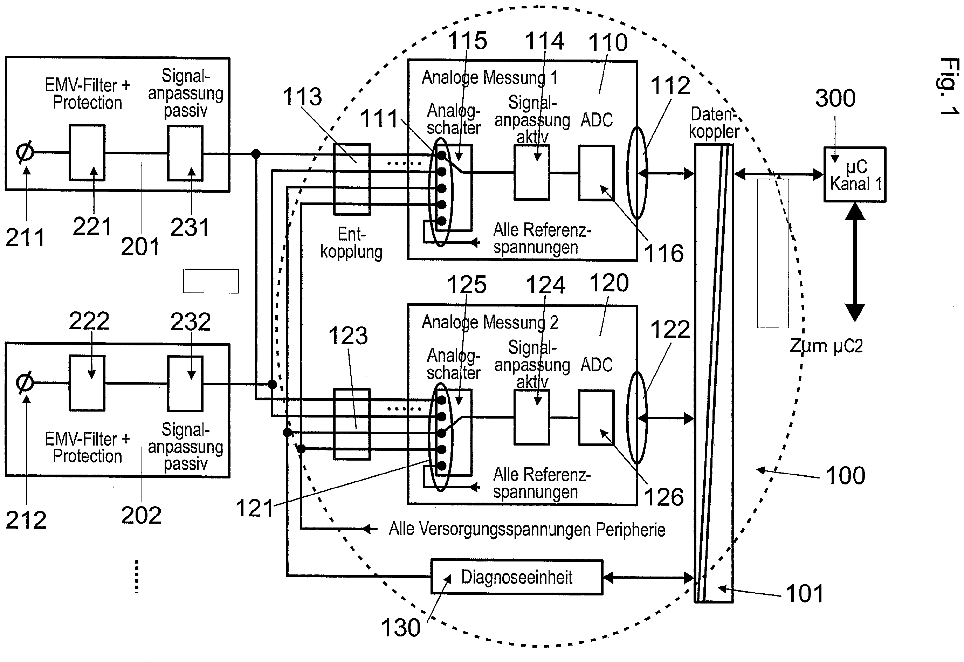

Bezug nehmend zunächst auf Fig. 1, ist eine Analogsignal-Eingangsschaltung mit einer ersten Anzahl von einem Analogsignal-Erfassungskanal 100, der eine Anzahl von zwei Analogsignal-Erfassungsschaltungen 110 und 120 und zumindest eine Diagnoseschaltung 130 besitzt, stark vereinfacht dargestellt.

Da die einzelnen Unterfunktionen einer Analogsignal-Erfassungsschaltung bisher nur mit einem sehr hohen Aufwand diagnostiziert werden können und unter Umständen keine rückwirkungsfreie Diagnose möglich ist, werden auch nach den vorgeschlagenen Lösungen zur Analogsignalerfassung zweckmäßig schon bewährte Analogschaltungskomponenten verwendet, wobei die Analogeingänge, wie nachfolgend aufgezeigt durch die erfindungsgemäßen Lösungen so miteinander verschaltet sind, dass die Gesamtschaltung nahe zu 100% getestet werden kann und die Analogschaltungskomponenten somit auch für die Verwendung in der Sicherheitstechnik geeignet sind. Hierzu ist zusätzlich zu den Analogsignal-Erfassungsschaltungen eine Diagnoseschaltung vorgesehen, die zweckmäßig so ausgeprägt ist, dass sie in der Lage ist, alle Signale zur Verfügung zu stellen, die für den vollständigen Test der Analogsignal-Erfassungsschaltungen notwendig sind. Der innere Aufbau dieser Analogsignal-Erfassungsschaltungen kann daher grundsätzlich wie bei Standard Analogmodulen implementiert sein, wobei die notwendige Diagnosedeckung durch die Diagnoseschaltung sichergestellt wird.

Dargestellt ist bei Fig. 1 ferner eine Anzahl von analogen Signaleingängen, gemäß Fig. 1 eine Anzahl von zwei analogen Signaleingängen 201 und 202. Es sei darauf hingewiesen, dass auch eine Anzahl von einem analogen Signaleingang oder auch von mehr als zwei analogen Signaleingängen von der Formulierung "eine Anzahl von analogen Signaleingängen" bzw. "eine zweite Anzahl von analogen Signaleingängen" vorgesehen sein kann und dementsprechend von den Ansprüchen umfasst ist, so dass die Anzahl zumindest 1 ist und ansonsten im wesentlichen beliebig groß sein kann.

Für die nachfolgende Beschreibung der Ausführungsform nach Fig. 1 wird davon ausgegangen, dass an zumindest einem Signaleingang 201 oder 202 ein einer analogen Eingangsgröße, wie z.B. Temperatur oder Druck, entsprechendes analoges Eingangsignal angelegt ist, welches vorzugsweise in der Prozessindustrie zur Prozessüberwachung dient und daher in zweckmäßiger Anwendung der Erfindung davon ausgegangen werden kann, dass ein solches analoges Eingangsignal für die Sicherheit des zu überwachenden, nicht näher dargestellten Prozesses, in der Regel von entscheidender Relevanz ist.

Wie ferner der Fig. 1 zu entnehmen, besitzt der Signaleingang 201 eine Eingangsklemme 211, und in zweckmäßiger Ausgestaltung ferner eine der Eingangsklemme 211 elektrisch nachgeschaltete Eingangsschutzschaltung 221. Die grundsätzlich nicht zwingend notwendige Eingangsschutzschaltung 221 kann jedoch vorteilhaft für die Analogsignal-Eingangsschaltung die Transienten begrenzen und/oder eine Störsignalfilterung durchführen. In optionaler zweckmäßiger alternativer Ergänzung besitzt der Signaleingang 201 ferner eine der Eingangsklemme 211 elektrisch nachgeschaltete passive Signalanpassungseinheit 231 oder, wie bei Fig. 1 zu sehen, in zweckmäßiger weiterer Ergänzung zur Eingangsschutzschaltung 221, wobei hierbei die passive Signalanpassungseinheit 231 zweckmäßig der Eingangsschutzschaltung 221 elektrisch nachgeschaltet ist.

Mit der passiven Signalanpassungseinheit 231 können die Strom- bzw. Spannungssignale auf einen gemeinsamen Messpegel gebracht werden.

In ähnlicher Weise können auch weitere analoge Signaleingänge zusätzlich zu einer Eingangsklemme eine Eingangsschutzschaltung und/oder eine passive Signalanpassungseinheit besitzen, wobei bei der Ausführung gemäß Fig. 1 auch der analoge Signaleingang 202 zusätzlich zu einer Eingangsklemme 212, eine elektrisch nachgeschaltete Eingangsschutzschaltung 222 und eine dieser elektrisch nachgeschaltete Signalanpassungseinheit 232 besitzt.

Der Analogsignal-Erfassungskanal 100 ist nunmehr ausgebildet, ein an dem analogen Signaleingang 201 oder 202 anliegendes, jedoch nicht dargestelltes analoges Eingangssignal zu erfassen und ansprechend auf ein erfasstes analoges Eingangssignal ein Ausgangssignal, wie nachfolgend detaillierter beschrieben, auszugeben.

Der Analogsignal-Erfassungskanal 100 beherbergt hierzu gemäß der in Fig. 1 dargestellten Lösung der Erfindung jeweils zwei Analogsignal-Erfassungsschaltungen 110 und 120 und zumindest eine erste Verbindungsauswahlvorrichtung 115, 125. Der Analogsignal-Erfassungskanal 100 beherbergt zweckmäßig auch die Diagnoseschaltung 130. Die erste Verbindungsauswahlvorrichtung ist in zweckmäßiger Ausgestaltung als Analogschalteinheit ausgebildet, wobei bevorzugt in jeder Analogsignal-Erfassungsschaltung 110 und 120 jeweils eine Analogschalteinheit 115 bzw. 125 beherbergt ist.

Jede Analogsignal-Erfassungsschaltung 110 und 120 besitzt ferner eine erste Anschlusseinrichtung 111 bzw. 121 und eine zweite Anschlusseinrichtung 112 bzw. 122. Jede der Analogsignal-Erfassungsschaltungen 110 und 120 ist mit deren erster Anschlusseinrichtung 111 bzw. 121 mit demselben analogen Signaleingang, z.B. 201 oder 202, zur Erfassung eines analogen Eingangssignals zumindest zeitlich nacheinander verbindbar, wobei beide Analogsignal-Erfassungsschaltungen 110 und 120 ausgebildet sind, ansprechend auf erfasste, einander entsprechende analoge Eingangssignale an deren zweiten Anschlusseinrichtungen 112 bzw. 122 einander einsprechende Ausgangssignale auszugeben.

Im normalen Betrieb der Analogsignal-Eingangsschaltung und also für die Erfassung des an einem analogen Signaleingang 201 oder 202 anliegenden analogen Eingangssignals und für die auf das erfasste analoge Eingangssignal ansprechende Ausgabe des Ausgangssignals durch den Analogsignal-Erfassungskanal 100 ist jedoch jeweils nur eine der zwei beherbergten Analogsignal-Erfassungsschaltungen 110 und 120 für einen bestimmbaren Zeitraum wechselnd ausgewählt, mit deren erster Anschlusseinrichtung 111 bzw. 121 mit diesem analogen Signaleingang zur Erfassung dieses analogen Eingangssignals verbunden zu werden und ansprechend auf das erfasste analoge Eingangssignal an deren zweiter Anschlusseinrichtung 112 bzw. 122 als Ausgangssignal das Ausgangssignal des Analogsignal-Erfassungskanals auszugeben. Die jeweils andere Analogsignal-Erfassungsschaltung hingegen ist im normalen Betrieb für diesen bestimmbaren Zeitraum ausgewählt, zu Test- und/oder Diagnosezwecke verwendet zu werden und z.B. mit der Diagnoseschaltung 130 verbunden zu werden, und also für diesen bestimmbaren Zeitraum nicht mit deren erster Anschlusseinrichtung mit dem analogen Signaleingang zur Erfassung des analogen Eingangssignals verbunden zu werden. Die erste Verbindungsauswahlvorrichtung 115, 125 ist hierzu ausgebildet, die jeweilige erste Anschlusseinrichtung 111, 121 ausgewählt zumindest entweder mit diesem zu verbindenden analogen Signaleingang oder mit der Diagnoseschaltung zu verbinden.

Bei einem wie in Fig. 1 dargestellten aktuellen Zustand, ist also z.B. die Analogsignal-Erfassungsschaltung 110 ausgewählt bzw. vorgesehen, mit deren erster Anschlusseinrichtung 111 mit dem analogen Signaleingang 201 zur Erfassung des daran anliegenden analogen Eingangssignals verbunden zu sein und ansprechend auf das erfasste analoge Eingangssignal an deren zweiter Anschlusseinrichtung 112 als Ausgangssignal das Ausgangssignal des Analogsignal-Erfassungskanals auszugeben und die Analogsignal-Erfassungsschaltung 120 ist vorgesehen, zu Diagnosezwecken mit der Diagnoseschaltung 130 verbunden zu sein.

Die bei der Ausgestaltung gemäß Fig. 1 die erste Verbindungsauswahlvorrichtung bereitstellenden Analogschalteinheiten 115 und 125 verbinden entsprechend in gegenseitiger Abstimmung die erste Anschlusseinrichtung 111 mit dem analogen Signaleingang 201 und die erste Anschlusseinrichtung 121 mit der Diagnoseschaltung 130.

Zweckmäßig ist die erste Verbindungsauswahlvorrichtung bzw. sind die bei Fig. 1 die erste Verbindungsauswahlvorrichtung bereitstellenden zwei Analogschalteinheiten 115 und 125 so ausgebildet, dass es außerdem möglich ist, beide Analogsignal-Erfassungsschaltungen 110 oder 120 falls erwünscht auch gleichzeitig mit demselben Signaleingang zu verbinden. Dies kann insbesondere beim Umschalten der Analogsignal-Erfassungsschaltungen 110 und 120 der Fall sein, denn werden beim Umschalten zum Testen beide Analogsignal-Erfassungsschaltungen 110 und 120 für eine kurze Zeit parallel an demselben Signaleingang betrieben, können die Messergebnisse verglichen werden, welches folglich eine 100% Diagnosedeckung der Analogschalter ermöglicht. In diesem Fall werden folglich die von den Analogsignal-Erfassungsschaltungen 110 und 120 ausgegebenen Ausgangssignale, z.B. wie an späterer Stelle beschrieben, der Diagnoseschaltung 130 zugeführt.

Den ersten Anschlusseinrichtungen 111 und 121 ist ferner zweckmäßig jeweils eine Entkopplungsschaltung 113 bzw. 123 zugeordnet, über welche jeweils die ersten Anschlusseinrichtungen 111 oder 121 der Analogsignal-Erfassungsschaltungen 110 oder 120 mit den Signaleingängen 201 und 202 mittels der ersten Verbindungsauswahlvorrichtung verbunden werden können. Die Entkopplungsschaltungen 113 und 123 verhindern Rückwirkungen der Analogsignal- Erfassungsschaltungen 110 oder 120 untereinander oder auf die Signaleingänge 201 und 202 sowie Rückwirkungen der Signaleingänge untereinander und sind in der Regel fehlersicher ausgeführt und bedürfen typischer Weise keiner Diagnose.

Weitere an die erste Verbindungsauswahlvorrichtung geführte Signalpfade, wie insbesondere von der Diagnoseeinrichtung 130 kommende, um die ersten Anschlusseinrichtungen 111 oder 121 der Analogsignal- Erfassungsschaltungen 110 oder 120 mit diesen Signalpfaden verbinden zu können, zum Einspeisen von Test- und Diagnosesignalen zu Diagnosezwecken der Analogsignal-Erfassungsschaltungen, werden somit zweckmäßig gleichermaßen über die Entkopplungsschaltungen 113 und 123 geführt. Aber auch zur internen Strom- und Spannungsquellenüberwachung vorgesehene, Versorgungsspannungen der Peripherie, sowie diverse für Diagnosezwecke benötigte Referenzspannungen führende und andere Signalpfade können über die Entkopplungsschaltungen 113 und 123 an die erste Verbindungsauswahlvorrichtung geführt werden, um im Bedarfsfall die ersten Anschlusseinrichtungen 111 oder 121 der Analogsignal-Erfassungsschaltungen 110 oder 120 mit diesen Signalpfaden verbinden zu können. Wie bei Fig. 1 zu sehen, sind beim dargestellten Ausführungsbeispiel alle weiteren für Diagnosezwecke benötigten Referenzspannungen, die nicht von der Diagnoseschaltung 130 kommen, jedoch nicht über die Entkopplungsschaltungen 113 und 123 an die erste Verbindungsauswahlvorrichtung geführt.

Mit den bei Fig. 1 dargestellten Analogschalteinheiten 115 und 125 können somit auf äußerst einfache Weise ausgewählte einzelne Analogsignale an die jeweilige Analogsignal-Erfassungsschaltung 110 bzw. 120 angelegt werden. Die Analogschalteinheiten 115 und 125 werden durch die Umschaltung der anzulegenden Signale und durch den vorerwähnten Test durch die Diagnoseeinheit mit getestet.

Wenn zum Testen beim vorerwähnten Umschalten der Analogsignal-Erfassungsschaltungen 110 und 120 beide Analogsignal-Erfassungsschaltungen 110 und 120 für eine kurze Zeit parallel mit demselben Eingangssignal betrieben und die Ausgangssignale verglichen werden, ermöglicht dies jedoch auch im Betrieb eine 100% Diagnosedeckung der Analogschalteinheiten 115 und 125 im Betrieb.

Wie bei Fig. 1 ferner zu sehen, besitzt jede der Analogsignal-Erfassungsschaltungen 110 und 120 zweckmäßig eine aktive Signalanpassungseinrichtung 114 bzw. 124 welchen die einzelnen, an die jeweilige Analogsignal-Erfassungsschaltung 110 bzw. 120 angelegten Analogsignale zur anwendungsspezifischen Verarbeitung der Analogsignale zugeführt werden und gegebenenfalls einen Analog/DigitalWandler 116 bzw. 126, wobei der jeweilige digitale Signalanschluss des Analog/Digital-Wandlers an die jeweilige zweite Anschlusseinrichtung 112 bzw. 122 geschaltet ist und der jeweilige analoge Signalanschluss des Analog/Digital-Wandlers in Richtung zur ersten Verbindungsauswahleinrichtung geschaltet und also gemäß Beispiel nach Fig. 1 an die aktive Signalanpassungseinrichtung 114 bzw. 124 geschaltet ist.

Um in praktischer Weise auch die zweiten Anschlusseinrichtungen 112 und 122 entsprechend ausgewählt gegebenenfalls mit einer für die weitere Verarbeitung des Ausgangssignals des Analogsignal-Erfassungskanals vorgesehenen, insbesondere anwendungsspezifischen, Verarbeitungsvorrichtung 300 oder auch auf einfache Weise mit der Diagnoseschaltung 130 zu verbinden, besitzt der Analogsignal-Erfassungskanal 100 zweckmäßig eine zweite Verbindungsauswahlvorrichtung 101, welche ausgebildet ist, insbesondere in Abstimmung mit der ersten Verbindungsauswahlvorrichtung, diese Verbindungen zu bewirken.

Es sei darauf hingewiesen, dass die Ansteuerung der ersten Verbindungsauswahleinrichtung zur wechselnden Auswahl der Analogsignal-Erfassungsschaltungen, um die eine oder andere für einen bestimmbaren Zeitraum mit einem bestimmten analogen Signaleingang zur Erfassung von analogen Eingangssignalen zu verbinden bzw. für Test- und/oder Diagnosezwecke zu verwenden, und der gegebenenfalls vorhandenen zweiten Verbindungsauswahleinrichtung nicht in den Zeichnungen dargestellt ist, jedoch auf für den Fachmann an und für sich bekannte Maßnahmen umsetzbar ist. Da die Art der Ansteuerung ferner kein wesentlicher Bestandteil der Erfindung ist, wird sie auch nicht näher beschrieben. Die Ansteuerung kann jedoch z.B. durch die Diagnoseschaltung 130 selbst erfolgen oder, wenn, wie bei Fig. 1 dargestellt, z.B. ein Mikrocontroller als anwendungsspezifische Verarbeitungsvorrichtung 300 vorgesehen ist, auch durch diesen. Aufgrund der Nutzung eines wie bei Fig. 1 dargestellten Mikrocontrollers als weitere Verarbeitungsvorrichtung 300 ist folglich der Einsatz der Analog/Digital-Wandlern 116 bzw. 126 und der Einsatz einer digital arbeitenden Verbindungsauswahlvorrichtung 101, bei Fig. 1 als Datenkoppler bezeichnet, in praktischer Umsetzung besonders zweckmäßig.

Diese Diagnoseschaltung 130 beinhaltet jedoch zweckmäßig alle erforderlichen Testeinrichtungen, die für eine festgelegte Diagnosedeckung für den Test der Analogsignal-Erfassungsschaltungen 110 und 120 erforderlich sind. Auch deren Ansteuerung kann je nach Ausführung durch die Diagnoseschaltung 130 selbst erfolgen oder durch eine andere Einrichtung, wie z.B. den als Verarbeitungsvorrichtung 300 skizzierten Mikrokontroller, der z.B. mit einer Sicherheitslogik ausgebildet ist. Auch kann eine Aufgabenteilung der Diagnosefunktionalitäten zwischen der Diagnoseschaltung 130 und dem Mikrokontroller in Bezug auf die Ansteuerung vorgesehen sein.

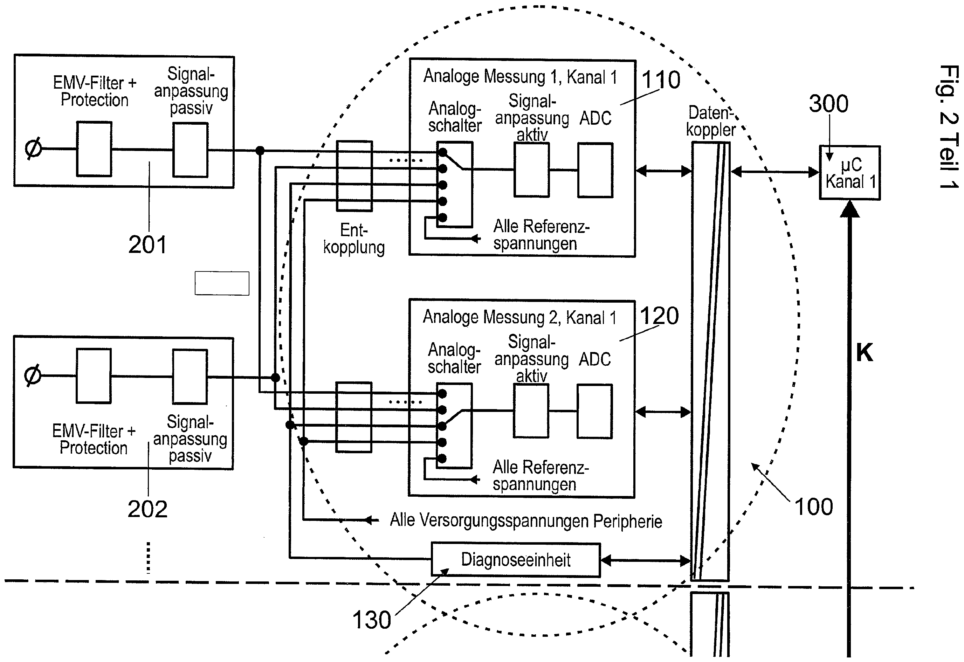

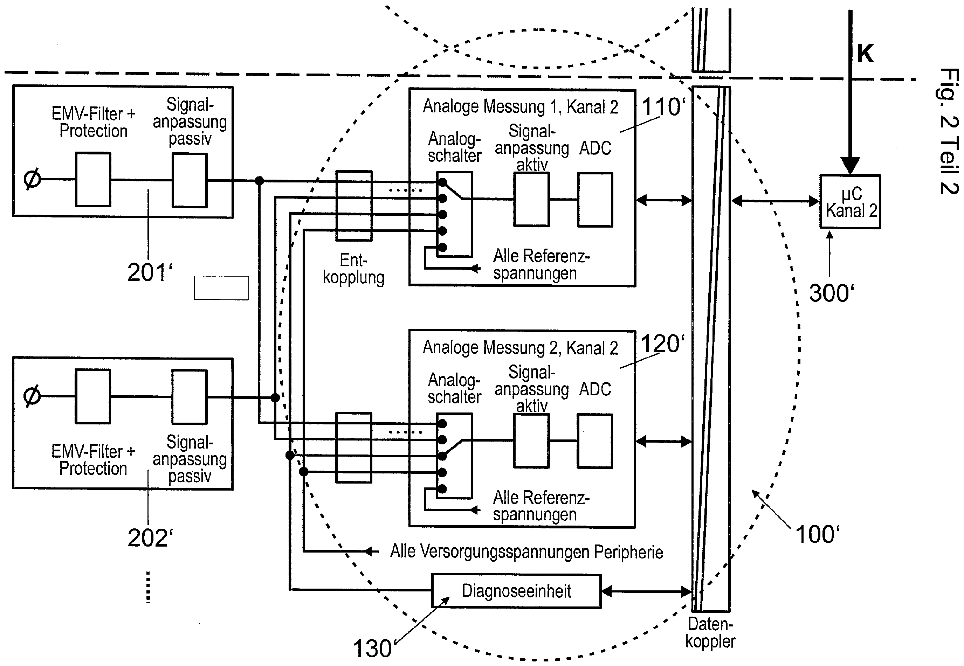

Nachfolgend wird auf Fig. 2 Bezug genommen, welche eine weitere bevorzugte und besonders zweckmäßige Ausgestaltungen aufweisende Ausführungsform einer Analogsignal-Eingangsschaltung, jedoch mit zwei Analogsignal-Erfassungskanälen dargestellt. Da die Komponenten im wesentlichen gleich sind oder gleich wirken, wie die in Bezug auf Fig. 1 beschriebenen, wird nachfolgend lediglich auf erfindungswesentliche Unterschiede eingegangen.

Der erste Analogsignal-Erfassungskanal 100 ist hierbei gemäß Fig. 2 oberhalb der gestrichelten Linie und der zweite Analogsignal-Erfassungskanal 100' unterhalb der gestrichelten Linie skizziert. In ähnlicher Weise können selbstverständlich weitere Analogsignal-Erfassungskanäle vorgesehen sein, so dass sich die Anzahl von Analogsignal-Erfassungskanälen entsprechend erhöht. Jeder Analogsignal-Erfassungskanal 100 und 100' besitzt hierbei wiederum zwei Analogsignal-Erfassungsschaltungen 110 und 120 bzw. 110' und 120', die in der bereits in Bezug auf Fig. 1 beschriebenen Weise aufgebaut sind, und eine Diagnoseschaltung 130 bzw. 130'.

Die bei Fig. 2 dargestellte Anzahl von zwei Analogsignal-Erfassungskanälen 100 und 100' können redundant betrieben werden oder zu einem Redundanzblock zusammengeschaltet sein. Wie bei Fig. 2 mit dem mit "K" bezeichneten Doppelpfeil dargestellt, kommunizieren hierzu z.B. jeweils eine einem Analogsignal-Erfassungskanal 100 nachgeschaltete Verarbeitungsvorrichtung 300 mit einer dem anderen Analogsignal-Erfassungskanal 100' nachgeschalteten Verarbeitungsvorrichtungen 300'. Ergänzend können auch die Signaleingänge redundant erfasst werden, d.h. am Signaleingang 201 und am Signaleingang 201' liegen die selben Signale an und auch am Signaleingang 202 und am Signaleingang 202' liegen die selben Signale an und können folglich mittels der Analogsignal-Erfassungskanäle 100 und 100' redundant erfasst werden.

Die Spannungsversorgung der Peripherie beider Analogsignal-Erfassungskanäle 100 und 100' oder auch weiterer, können durch die gleichen Versorgungsspannungen oder separat versorgt werden, insbesondere bei hoch verfügbaren Geräten kann die Versorgung der beiden Analogsignal-Erfassungskanäle 100 und 100' zweckmäßig unabhängig voneinander realisiert werden. Die Überwachung der einzelnen Spannungen erfolgt dann wiederum durch die Diagnoseschaltung 130 oder 130' des jeweiligen Analogsignal-Erfassungskanals 100 bzw. 100'.

Zusammenfassend lässt sich somit festhalten, dass zu jedem beliebigen Zeitpunkt die Erfassung der analogen Eingangssignale mittels der Analogsignal-Erfassungsschaltung 110 oder 120 eines jeden Analogsignal-Erfassungskanals 100, 100', die mit dem jeweils zu messenden Eingang (aus einer Anzahl von 1 bis n) verbunden ist, erfolgen kann. Diese Analogsignal-Erfassungsschaltung 110 oder 120 eines jeden Analogsignal-Erfassungskanals 100, 100' kann ferner zwischen den Signaleingängen umgeschaltet werden, um den Zustand der einzelnen analogen Signaleingänge nacheinander zu erfassen. Mit anderen Worten kann diese somit aktive Analogsignal-Erfassungsschaltung zwischen den einzelnen Signaleingängen zur Erfassung der Eingangswerte umgeschaltet werden, wobei die Umschaltung zwischen den Signaleingängen z.B. durch eine vorhergehende Priorisierung der einzelnen Signaleingängen gesteuert werden kann.

Die zweite Analogsignal-Erfassungsschaltung 120 bzw. 110 eines jeden Analogsignal-Erfassungskanals 100, 100', die im Regelbetrieb zu diesem Zeitpunkt nicht an einer Sicherheitsfunktion beteiligt sich, kann sich folglich im Test befinden, der durch die Diagnoseeinheit durchgeführt wird, ohne die Funktionalität des Analogsignal-Erfassungskanals 100, 100' und also eine mit diesem verbundene Sicherheitsfunktion in irgendeiner Weise zu beeinträchtigen. Sobald der Test bzw. die Diagnose vollständig abgeschlossen ist, kann die getestete bzw. diagnostizierte Analogsignal-Erfassungsschaltung wieder in die Sicherheitskette aufgenommen und die andere Analogsignal-Erfassungsschaltung aus der Sicherheitskette entfernt und mit der Diagnoseeinheit für die Testzwecke verbunden werden. Wurde auch diese Analogsignal-Erfassungsschaltung vollständig getestet, erfolgt z.B. eine weitere Umschaltung, bei der der Ausgangszustand wieder hergestellt wird. Außerdem ist es möglich, beide Analogsignal-Erfassungsschaltung eines Analogsignal-Erfassungskanals auch parallel zu betreiben, um z.B. die ermittelten Messwerte beider Analogsignal-Erfassungsschaltung miteinander zu vergleichen und somit die Diagnosedeckung noch weiter zu verbessern. Da während des Tests die zu testende Analogsignal-Erfassungsschaltung somit in keiner Sicherheitskette liegt, kann jede Analogsignal-Erfassungsschaltung zu 100% getestet werden. Folglich können die Diagnose-/Testimpulse jegliche Sicherheitsfunktion auch nicht beeinträchtigen und es können weitere Zustände getestet werden, die beim Betrieb in einer Sicherheitskette nicht zulässig wären, z.B. verschiedene Einstellungen einer aktiven Signalanpassung, z.B. der Verstärkung.

Im Fehlerfall gibt die erfindungsgemäße Analogsignal-Eingangschaltung die gesicherte Diagnose, welche der Analogschaltungen defekt ist und kann aufgrund der "überzähligen" Analogsignal-Erfassungsschaltung in jedem Analogsignal-Erfassungskanal somit im Fehlerfall auch einen abgesicherten Weiterbetrieb mit eingeschränkter Diagnose ermöglichen.

Ferner kann mittels der Diagnoseschaltung auch eine Kalibrierung einer Analogsignal-Erfassungsschaltung im laufenden Betrieb ohne zeitliche und/oder funktionale Beeinflussung der laufenden Messungen und der Gerätefunktion (Selbstkalibrierung) bewirkt werden. Da somit durch die Diagnoseeinheit die gesamte Analogsignal-Eingangsschaltung auch während der Laufzeit kalibriert werden kann, kann mit der Erfindung durch Testen bzw. Diagnostizieren der Analogsignal-Eingangsschaltung im Betrieb je nach Anwendung auch ein Proof-Test (vorheriger Funktionstest) vollständig ersetzt werden.

Da eine von der Diagnoseschaltung durchgeführte Diagnose keinen Einfluss auf das zeitliche Verhalten hat, weder in Bezug auf das die Analogsignal-Eingangsschaltung umfassende Gerät noch in Bezug auf die Geräte, deren Analogsignal an den Signaleingängen erfasst werden, kann die von der Diagnoseschaltung durchgeführte Diagnose damit z.B. auch weiterhin die synchrone Signalerfassung und Übergabe an das Überlagerte Netzwerk sicherstellen. So sind z.B. auch keine Testsignale an der Eingangsklemme eines Signaleingang sichtbar.

Die von der Diagnoseschaltung durchgeführte Diagnose kann folglich auch die Zustände der Analogsignal-Erfassungsschaltungen überprüfen, die in einer aktiven Messung der Eingangssignale unzulässig sind. Da somit insgesamt die Testtiefe gegenüber herkömmlichen Lösungen besser ist, verbessern sich folglich auch die Ergebnisse der Quantifizierung. Auch kann der Test bzw. die Diagnose parallel mit der Erfassung der analogen Eingangssignale, insbesondere auch parallel mit der Erfassung von für die Sicherheit eines Prozesses relevanten analogen Eingangssignale, laufen.

Die von der Diagnoseschaltung eingesetzten Diagnose-/Testpattern können z.B. auch aus dem Entwicklungsprozess entnommen werden, wodurch sich der Entwicklungsaufwand für die Entwicklung der Diagnoseschaltung reduziert. Auch bietet die Erfindung eine kostengünstige Realisierung, da jeweils für zwei Analogsignal-Erfassungsschaltungen nur eine Diagnoseeinheit benötigt wird.

Ein wesentlicher Aspekt der Erfindung liegt somit darin, dass eine Analogsignal-Erfassungsschaltung des Analogsignal-Erfassungskanals ein am analogen Signaleingang anliegendes Analogsignal erfasst, während eine weitere Analogsignal-Erfassungsschaltung des selben Analogsignal-Erfassungskanals für einen bestimmbaren Zeitraum getestet und/oder diagnostiziert wird. Nach dem Test bzw. der Diagnose können und werden diese daraufhin getauscht, d.h. die getestete Analogsignal-Erfassungsschaltung übernimmt nach dem Wechsel für einen bestimmbaren Zeitraum die Durchführung der Messungen, während die erste Analogsignal-Erfassungsschaltung getestet wird.

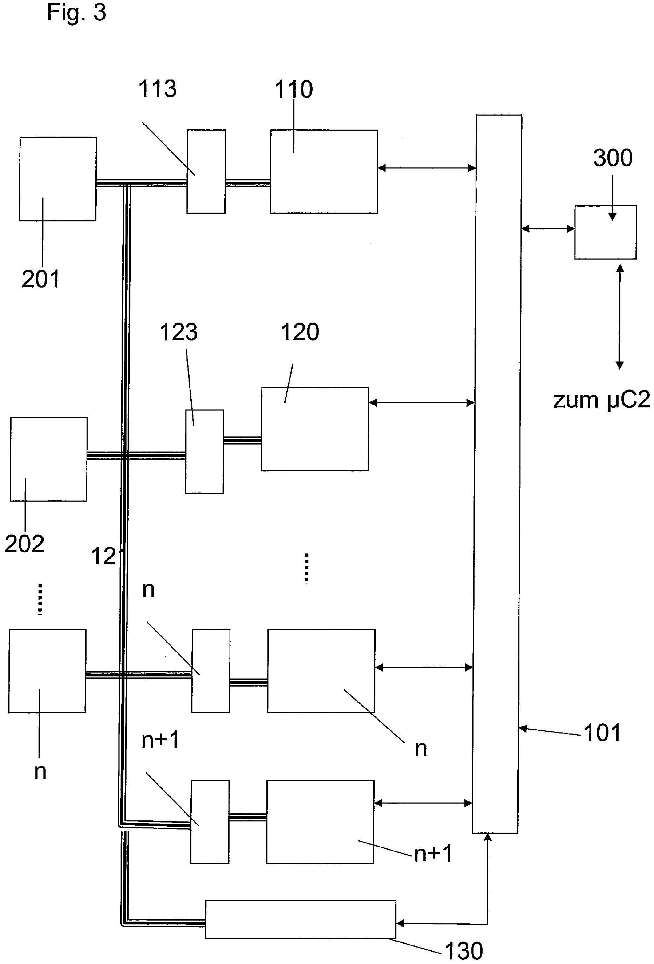

Während Fig. 1 und Fig. 2 Lösungen, insbesondere zur Erfassung langsamer analoger Eingangssignale, mit einer Anzahl von 1 bis n analogen Signaleingänge und mit je zwei Analogsignal-Erfassungsschaltungen pro Analog-Erfassungskanal skizzieren, bei denen also eine Analogsignal-Erfassungsschaltung zwischen den Signaleingängen verbunden wird, während die andere mit der Diagnoseeinheit oder weiteren Signalen wie Referenzspannungen und Versorgungsspannungen zur Durchführung von Messungen zu Testzwecken verbunden ist, wobei nach dem Test der Wechsel der beiden Analogsignal-Erfassungsschaltungen erfolgt, ist der Fig. 3 eine Skizze einer weiteren auf Fig. 1 basierenden Ausführungsform einer Analogsignal-Eingangsschaltung mit lediglich einem Analogsignal-Erfassungskanal zu entnehmen, welche insbesondere zur Erfassung schnellerer bzw. zeitkritischer analoger Eingangssignale nochmals verbessert ist. Da die Komponenten im wesentlichen gleich sind oder gleich wirken, wie die in Bezug auf Fig. 1 oder auf Fig. 2 beschriebenen, wird nachfolgend lediglich auf erfindungswesentliche Unterschiede eingegangen.

Bei der Lösung nach Fig. 3 ist wiederum eine Anzahl von 1 bis n analogen Signaleingängen vorhanden, jedoch beherbergt ein Analogsignal-Erfassungskanal eine Anzahl von wenigstens drei Analogsignal-Erfassungsschaltungen und maximal eine Anzahl von Analogsignal-Erfassungsschaltungen, die um eins größer als die Anzahl der analogen Signaleingängen ist.

Bei Fig. 3 ist die Anzahl von analogen Signaleingängen daher mit 201, 202 bis n angedeutet und die Anzahl von Analogsignal-Erfassungsschaltungen daher mit 110, 120 bis n, n+1 angedeutet. Entsprechend können den Analogsignal-Erfassungsschaltungen bzw. bei Fig. 3 nicht explizit dargestellten ersten Anschlusseinrichtungen ferner zweckmäßig jeweilige Entkopplungsschaltung 113, 123 bis n, n+1 zugeordnet sein, über welche die Analogsignal-Erfassungsschaltungen mit den Signaleingängen, der Diagnoseeinheit 130 oder weiteren Signalen wie Referenzspannungen und Versorgungsspannungen zur Durchführung von Messungen zu Testzwecken mittels der bei Fig. 3 nicht explizit dargestellten ersten Verbindungsauswahlvorrichtung verbunden werden können. Da jede der Analogsignal-Erfassungsschaltungen eines Analogsignal-Erfassungskanals 100 mit deren erster Anschlusseinrichtung mit jeweils einem analogen Signaleingang aus der Anzahl von analogen Signaleingängen zur Erfassung eines analogen Eingangssignals verbindbar ist, können folglich mehrere Signaleingänge gleichzeitig mit mehreren Analogsignal-Erfassungsschaltungen zur Durchführung der Messungen verbunden sein, also stehen je nach Ausführung maximal n Analogsignal-Erfassungsschaltungen für maximal n Signaleingänge zur Verfügung. Eine Analogsignal-Erfassungsschaltung ist für einen bestimmbaren Zeitraum wechselnd ausgewählt, z.B. gemäß Fig. 3 die Analogsignal-Erfassungsschaltung "n+1", getestet und/oder diagnostiziert zu werden, und also z.B. mit der Diagnoseeinheit 130 verbunden. Nach dem Test bzw. der Diagnose erfolgt wiederum der Wechsel der Analogsignal-Erfassungsschaltungen, d.h. die getestete Analogsignal-Erfassungsschaltung übernimmt die Durchführung einer Eingangssignalerfassung, wird also mit einem der Signaleingänge verbunden, während die Analogsignal-Erfassungsschaltung, die bis zu diesem Zeitpunkt mit diesem Signaleingang verbunden war, getestet wird. Diese Struktur ist folglich zur Erfassung schnellerer bzw. zeitkritischer Signale besser geeignet. Entsprechend zu den Ausführungsformen nach Fig. 1 und Fig. 2 können wiederum weitere Signale wie z.B. Referenzspannungen und Versorgungsspannungen zu Testzwecken gemessen werden und/oder mehrere Analogsignal-Erfassungskanäle parallel, insbesondere redundant oder zu einem Redundanzblock zusammengeschaltet, betrieben werden.

### Bezugszeichenliste

- 100, 100': Analogsignal-Erfassungskanal
- 101: zweite Verbindungsauswahlvorrichtung
- 110, 110', 120, 120': Analogsignal-Erfassungsschaltung
- 111, 121: erste Anschlusseinrichtung
- 112, 122: zweite Anschlusseinrichtung
- 113, 123: Entkopplungsschaltung
- 114, 124: aktive Signalanpassungseinrichtung
- 115, 125: erste Verbindungsauswahlvorrichtung, insbesondere Analogschalteinheit
- 116, 126: Analog/Digital-Wandler
- 130, 130': Diagnoseschaltung
- 201, 201', 202, 202': analoger Signaleingang
- 211, 212: Eingangsklemme
- 221, 222: Eingangsschutzschaltung
- 231, 232: passive Signalanpassungseinheit
- 300, 300': Verarbeitungsvorrichtung

## Patentansprüche

1. Analogsignal-Eingangsschaltung zur Verarbeitung von für die Sicherheit eines Prozesses relevanten analogen Eingangssignalen, mit einer ersten Anzahl von wenigstens zwei Analogsignal-Erfassungskanälen (100; 100'), die redundant betrieben werden können oder zu einem Redundanzblock zusammenschaltbar sind, wobei
- jeder Analogsignal-Erfassungskanal (100; 100') ausgebildet ist, ein an einem analogen Signaleingang aus einer zweiten Anzahl von analogen Signaleingängen (201, 202; 201', 202') anliegendes analoges Eingangssignal zu erfassen und ansprechend auf ein erfasstes analoges Eingangssignal ein Ausgangssignal auszugeben;
- jeder Analogsignal-Erfassungskanal (100; 100') jeweils zwei Analogsignal-Erfassungsschaltungen (110, 120; 110', 120'), zumindest eine Diagnoseschaltung (130; 130') und zumindest eine erste Verbindungsauswahlvorrichtung (115, 125) beherbergt;
- jede Analogsignal-Erfassungsschaltung (110, 120; 110', 120') eine erste Anschlusseinrichtung (111, 121) und eine zweite Anschlusseinrichtung (112, 122) besitzt;
- jede der Analogsignal-Erfassungsschaltungen (110, 120; 110', 120') eines Analogsignal-Erfassungskanals (100; 100') mit deren erster Anschlusseinrichtung (111, 121) mit demselben analogen Signaleingang aus der zweiten Anzahl von analogen Signaleingängen (201, 202; 201', 202') zur Erfassung eines analogen Eingangssignals zumindest zeitlich nacheinander verbindbar ist und beide Analogsignal-Erfassungsschaltungen (110, 120; 110', 120') eines Analogsignal-Erfassungskanals (100; 100') ausgebildet sind, ansprechend auf erfasste, einander entsprechende analoge Eingangssignale an deren zweiten Anschlusseinrichtungen (112, 122) einander entsprechende Ausgangssignale auszugeben;
- je Analogsignal-Erfassungskanal (100; 100') für die Erfassung des an einem analogen Signaleingang aus der zweiten Anzahl von analogen Signaleingängen anliegenden analogen Eingangssignals und für die auf das erfasste analoge Eingangssignal ansprechende Ausgabe des Ausgangssignals jeweils eine der zwei beherbergten Analogsignal-Erfassungsschaltungen für einen bestimmbaren Zeitraum wechselnd ausgewählt ist, nicht mit deren erster Anschlusseinrichtung mit diesem analogen Signaleingang zur Erfassung dieses analogen Eingangssignals verbunden sondern für Test- und/oder Diagnosezwecke verwendet zu werden und die jeweils andere der zwei beherbergten Analogsignal-Erfassungsschaltungen (110, 120; 110', 120') für diesen bestimmten Zeitraum ausgewählt ist, mit deren erster Anschlusseinrichtung mit diesem analogen Signaleingang zur Erfassung dieses analogen Eingangssignals verbunden zu werden und ansprechend auf das erfasste analoge Eingangssignal an deren zweiter Anschlusseinrichtung als Ausgangssignal das Ausgangssignal des Analogsignal-Erfassungskanals auszugeben und, wobei die erste Verbindungsauswahlvorrichtung (115, 125) hierzu ausgebildet ist, die jeweilige erste Anschlusseinrichtung (111, 121) der zwei beherbergten Analogsignal-Erfassungsschaltungen (110, 120; 110', 120') ansprechend auf die Auswahl zumindest entweder mit diesem zu verbindenden analogen Signaleingang oder mit der Diagnoseschaltung (130) zum Einspeisen von Test- und Diagnosesignalen zu verbinden.

2. Analogsignal-Eingangsschaltung zur Verarbeitung von für die Sicherheit eines Prozesses relevanten analogen Eingangssignalen, mit einer ersten Anzahl von wenigstens zwei Analogsignal-Erfassungskanälen (100; 100'), die redundant betrieben werden können oder zu einem Redundanzblock zusammenschaltbar sind, wobei
- jeder Analogsignal-Erfassungskanal (100; 100') ausgebildet ist, an einer zweiten Anzahl von wenigstens zwei analogen Signaleingängen (201, 202; 201', 202') anliegende analoge Eingangssignale zu erfassen und ansprechend auf erfasste analoge Eingangssignale Ausgangssignale auszugeben;
- jeder Analogsignal-Erfassungskanal (100; 100') jeweils eine dritte Anzahl von Analogsignal-Erfassungsschaltungen (110, 120; 110', 120'), zumindest eine Diagnoseschaltung (130; 130') und zumindest eine erste Verbindungsauswahlvorrichtung (115, 125) beherbergt;
- wobei die dritte Anzahl wenigstens drei beträgt und maximal um eins größer als die zweite Anzahl ist;
- jede Analogsignal-Erfassungsschaltung (110, 120; 110', 120') eine erste Anschlusseinrichtung (111, 121) und eine zweite Anschlusseinrichtung (112, 122) besitzt;
- jede der Analogsignal-Erfassungsschaltungen (110, 120; 110', 120') eines Analogsignal-Erfassungskanals (100; 100') mit deren erster Anschlusseinrichtung (111, 121) mit jeweils einem analogen Signaleingang aus der zweiten Anzahl von analogen Signaleingängen (201, 202; 201', 202') zur Erfassung eines analogen Eingangssignals verbindbar ist, jede der Analogsignal-Erfassungsschaltungen (110, 120; 110', 120') eines Analogsignal-Erfassungskanals (100; 100') mit deren erster Anschlusseinrichtung (111, 121) mit demselben analogen Signaleingang aus der zweiten Anzahl von analogen Signaleingängen (201, 202; 201', 202') zur Erfassung eines analogen Eingangssignals zumindest zeitlich nacheinander verbindbar ist und alle der dritten Anzahl von Analogsignal-Erfassungsschaltungen (110, 120; 110', 120') eines Analogsignal-Erfassungskanals (100; 100') ausgebildet sind, ansprechend auf erfasste, einander entsprechende analoge Eingangssignale an deren zweiten Anschlusseinrichtungen (112, 122) einander entsprechende Ausgangssignale auszugeben;
- je Analogsignal-Erfassungskanal (100; 100') für die Erfassung von an Signaleingängen aus der zweiten Anzahl von analogen Signaleingängen anliegenden analogen Eingangssignalen und für die auf die erfassten analogen Eingangssignale ansprechenden Ausgaben der Ausgangssignale jeweils eine Analogsignal-Erfassungsschaltung für einen bestimmbaren Zeitraum wechselnd ausgewählt ist, nicht mit deren erster Anschlusseinrichtung mit einem analogen Signaleingang zur Erfassung eines analogen Eingangssignals verbunden sondern für Test- und/oder Diagnosezwecke verwendet zu werden, und alle bis auf diese eine der dritten Anzahl von beherbergten Analogsignal-Erfassungsschaltungen (110, 120; 110', 120') jeweils für diesen bestimmten Zeitraum ausgewählt sind, mit deren ersten Anschlusseinrichtungen mit bestimmten analogen Signaleingängen aus der zweiten Anzahl von analogen Signaleingängen zur Erfassung von analogen Eingangssignalen verbunden zu werden und ansprechend auf die erfassten analogen Eingangssignale an deren zweiten Anschlusseinrichtungen als Ausgangssignale die Ausgangssignale des Analogsignal-Erfassungskanals auszugeben, wobei die erste Verbindungsauswahlvorrichtung (115, 125) hierzu ausgebildet ist, die jeweiligen ersten Anschlusseinrichtungen (111, 121) aller beherbergten Analogsignal-Erfassungsschaltungen (110, 120; 110', 120') ansprechend auf die Auswahl zumindest entweder mit einem bestimmten zu verbindenden analogen Signaleingang oder mit der Diagnoseschaltung (130) zum Einspeisen von Test- und Diagnosesignalen zu verbinden.

3. Analogsignal-Eingangsschaltung nach Anspruch 1 oder 2, wobei zumindest ein Analogsignal-Erfassungskanal (100, 100') zur Verarbeitung auch von digitalen Signalen ausgebildet ist und jede Analogsignal-Erfassungsschaltung (110, 120) dieses Analogsignal-Erfassungskanals einen Analog/Digital-Wandler (116, 126) beherbergt, dessen digitaler Signalanschluss an die jeweilige zweite Anschlusseinrichtung (112, 122) geschaltet ist und dessen analoger Signalanschluss in Richtung zur ersten Verbindungsauswahleinrichtung geschaltet ist.

4. Analogsignal-Eingangsschaltung nach einem der vorstehenden Ansprüche, wobei jeder Analogsignal-Erfassungskanal eine zweite Verbindungsauswahlvorrichtung (101) besitzt, welche ausgebildet ist, in Abstimmung mit der ersten Verbindungsauswahlvorrichtung (115, 125) die zweiten Anschlusseinrichtungen (112, 122) entsprechend ausgewählt mit einer für die weitere Verarbeitung von Ausgangssignalen des Analogsignal-Erfassungskanals vorgesehenen Verarbeitungsvorrichtung (300) oder mit der Diagnoseschaltung (130) zu verbinden.

5. Analogsignal-Eingangsschaltung nach einem der vorstehenden Ansprüche, wobei die erste Verbindungsauswahlvorrichtung (115, 125) ausgebildet ist, so dass eine Verbindung einer jeweiligen ersten Anschlusseinrichtung (111, 112) mit dem zu verbindenden analogen Signaleingang, mit der Diagnoseschaltung (130), mit wenigstens einer Referenzspannung oder mit wenigstens einer Versorgungsspannung eines Peripherieeinrichtung auswählbar ist.

6. Analogsignal-Eingangsschaltung nach einem der vorstehenden Ansprüche, wobei die Analogsignal-Erfassungsschaltung eine aktive Signalanpassungseinrichtung (114, 124) beherbergt.

7. Analogsignal-Eingangsschaltung nach einem der vorstehenden Ansprüche, wobei der ersten Anschlusseinrichtung (111, 112) eine Entkopplungsschaltung (113, 123) zugeordnet ist.

8. Analogsignal-Eingangsschaltung nach einem der vorstehenden Ansprüche, wobei zumindest ein analoger Signaleingang aus der zweiten Anzahl von analogen Signaleingängen (201, 202, 201', 202') zusätzlich zu einer Eingangsklemme (211, 212) eine Eingangsschutzschaltung (221, 222) und/oder eine passive Signalanpassungseinheit (231, 232) besitzt.

9. Analogsignal-Eingangsschaltung nach einem der vorstehenden Ansprüche, wobei die erste Verbindungsauswahlvorrichtung als Analogschalteinheit (115, 125) ausgebildet ist, wobei in jeder Analogsignal-Erfassungsschaltung (110,120) jeweils eine solche Analogschalteinheit beherbergt ist.

## Claims

1. An analog signal input circuit to process analog input signals relevant for the safety of a process, with a first number of at least two analog signal detection channels (100; 100'), which can be operated redundantly or can be connected to form a redundancy block, wherein
- each analog signal detection channel (100; 100') being embodied to detect an analog input signal applied at an analog signal input from a second number of analog signal inputs (201, 202; 201', 202') and, responding to a detected analog input signal, issuing an output signal;
- each analog signal detection channel (100; 100') respectively including two analog signal detection circuits (110, 120; 110', 120'), at least one diagnostics circuit (130; 130') and at least one first connection selection device (115, 125);
- each analog signal detection circuit (110, 120; 110', 120') comprising a first connection device (111, 121) and a second connection device (112, 122);
- each of the analog signal detection circuits (110, 120; 110', 120') of an analog signal detection channel (100; 100') being able to connect to its first connection device (111, 121) with the same analog signal input of the second number of analog signal inputs (201, 202; 201', 202') for detecting an analog input signal, at least successively, and both analog signal detection circuits (110, 120; 110', 120') of an analog signal detection channel (100; 100') being embodied such that, responding to detected matching analog input signals, issuing at their second connection devices (112, 122) matching output signals;
- each analog signal detection channel (100; 100') for the detection of the analog input signal applied at one analog signal input from the second number of analog signal inputs and for the responding output of the output signal for the detected analog input signal respectively one of the two included analog signal detection circuits is selected alternatingly for a certain period of time, not connected to its first connection device with this analog signal input for detecting this analog input signal, but used for test and/or diagnostic purposes, and the respectively other of the two included analog signal detection circuits (110, 120; 110', 120') is selected for this certain period of time to be connected to their first connection device with this analog signal input for detecting this analog input signal and responding to the detected analog input signal issuing the output signal of the analog signal detection channel at this second connection device as the output signal, with the first connection selection device (115, 125) being embodied for the purpose of connecting the respectively first connection device (111, 121) of the two included analog signal detection circuits (110, 120; 110', 120') in response to the selection at least to either the analog signal input to be connected or to the diagnostics circuit for introducing test and diagnostic signals.

2. Analog signal input circuit to process analog input signals relevant for the safety of a process with a first number of at least two analog signal detection channels (100; 100'), which can be operated redundantly or can be connected to form a redundancy block, with
- each analog signal detection channel (100; 100') being formed, to detect analog input signals applied at a second number of at least two analog signal inputs (201, 202; 201', 202') and in response issue output signals for the detected input signals;
- each analog signal detection channel (100; 100') respectively showing a third number of analog signal detection circuits (110, 120; 110', 120'), at least one diagnostics circuit (130; 130') and at least one first connection selection device (115, 125);
- with the third number amounting to at least three and being maximally greater by one than the second number;
- each analog signal detection circuit (110, 120; 110', 120') comprising a first connection device (111, 121) and a second connection device (112, 122);
- each of the analog signal detection circuits (110, 120; 110', 120') of an analog signal detection channel (100; 100') with its first connection device (111, 121) is able to be connected to respectively one analog signal input from the second number of analog signal inputs (201, 202; 201', 202') for detecting an analog input signal, with it being possible to connect each of the analog signal detection circuits (110, 120; 110' 120') of an analog signal detection channel (100; 100') with its first connection device (111, 121) to the same analog signal input of the second number of analog signal inputs (201, 202; 201', 202') for detecting an analog input signal, at least successively, and all of the third number of analog signal detection circuits (110, 120, 110', 120') of an analog signal detection channel (100; 100') being embodied, to issue at their second connection devices (112, 122) matching output signals, responding to detected, matching analog input signals;
- one analog signal detection circuit is selected alternatingly for a certain period of time for each analog signal detection channel (100; 100') for detecting analog signal input signals applied at signal inputs of the second number of analog signal inputs and for the respective output of output signals in response to the detected analog input signals, not connected to its first connection device with an analog signal input for detecting an analog input signal, but used for test and/or diagnostic purposes, and all except for this one being selected from the third number of included analog signal detection circuits (110, 120; 110', 120'), each for this certain period of time, to be connected to the first connection devices with certain analog signal inputs of the second number of analog signal inputs for detecting analog input signals, and issuing at their second connection devices as output signals the output signals of the analog signal detection channel, responding to the detected analog input signals, with the first connection selection device (115, 125) being embodied for the purpose of connecting the respectively first connection devices (111, 121) of all included analog signal detection circuits (110, 120; 110', 120') in response to the selection at least to either a certain analog signal input to be connected or to the diagnostics circuit for introducing test and diagnostic signals.

3. Analog signal input circuit according to claim 1 or 2, with at least one analog signal detection channel (100, 100') being embodied to process also digital signals, and each analog signal detection circuit (110, 120) of this analog signal detection channel comprising an analog/digital converter (116, 126), with its digital signal connection being switched to the respectively second connection device (112, 122) and with its analog signal connection being switched in the direction towards the first connection selection device.

4. Analog signal input circuit according to any of the preceding claims, with each analog signal detection channel having a second connection selection device (101), which is embodied to connect, in coordination with the first connection selection device (115, 125), the second connection devices (112, 122) accordingly selected with a processing device (300) provided for the further processing of output signals of the analog signal detection channel or with a diagnostics circuit (130).

5. Analog signal input circuit according to any of the preceding claims, with the first connection selection device (115, 125) being embodied to allow selecting a connection of one respective first connection device (111, 112) to the analog signal input to be connected, to the diagnostics circuit (130), to at least one reference voltage, or to at least one supply voltage of a peripheral device.

6. Analog signal input circuit according to any of the preceding claims, with the analog signal detection circuit including an active signal adjustment device (114, 124).

7. Analog signal input circuit according to anyone of the preceding claims, with a decoupling circuit (113, 123) being allocated to the first connection device (111, 112).

8. Analog signal input circuit according to any of the preceding claims, with at least one analog signal input of the second number of analog signal inputs (201, 202, 201', 202'), in addition to an input terminal (211, 212), comprising an input protection circuit (221, 222) and/or a passive signal adjustment unit (231, 232).

9. Analog signal input circuit according to any of the preceding claims, with the first connection selection device being embodied as an analog switching unit (115, 125), with one such analog switching unit being included in each analog signal detection circuit (110, 120).

## Revendications

1. Circuit d'entrée de signaux analogiques pour le traitement de signaux d'entrée analogiques pertinents pour la sécurité d'un processus, avec un premier nombre d'au moins deux canaux de détection de signaux analogiques (100 ; 100') pouvant être mis en service de manière redondante ou pouvant être accouplés pour former un bloc redondant, dans lequel :
- chaque canal de détection de signaux analogiques (100 ; 100') est prévu pour détecter un signal d'entrée analogique présent sur une entrée de signaux analogiques parmi un deuxième nombre d'entrées de signaux analogiques (201, 202 ; 201', 202') et émettre un signal de sortie en réaction à un signal d'entrée analogique détecté ;
- chaque canal de détection de signaux analogiques (100 ; 100') héberge respectivement deux circuits de détection de signaux analogiques (110, 120 ; 110', 120'), au moins un circuit de diagnostic (130 ; 130') et au moins un premier dispositif de sélection de liaison (115, 125) ;
- chaque circuit de détection de signaux analogiques (110, 120 ; 110', 120') est pourvu d'un premier système de raccordement (111, 121) et d'un deuxième système de raccordement (112, 122) ;
- chacun des circuits de détection de signaux analogiques (110, 120 ; 110', 120') d'un canal de détection de signaux analogiques (100 ; 100') peut être relié au moins successivement dans le temps avec son premier système de raccordement (111, 121) à la même entrée de signaux analogiques parmi le deuxième nombre d'entrées de signaux analogiques (201, 202 ; 201', 202') pour la détection d'un signal d'entrée analogique et les deux circuits de détection de signaux analogiques (110, 120 ; 110', 120') d'un canal de détection de signaux analogiques (100 ; 100') sont prévus pour, en réaction à des signaux d'entrée analogiques détectés correspondant les uns aux autres, émettre des signaux de sortie correspondant les uns aux autres sur leurs deuxièmes systèmes de raccordement (112, 122) ;
- un des deux circuits de détection de signaux analogiques hébergés est sélectionné en alternance pendant un intervalle de temps déterminable, par canal de détection de signaux analogiques (100 ; 100') pour la détection du signal d'entrée analogique présent sur une entrée de signaux analogiques parmi le deuxième nombre d'entrées de signaux analogiques et pour l'émission du signal de sortie en réaction au signal d'entrée analogique détecté, non pour être raccordé avec son premier système de raccordement à ladite entrée de signaux analogiques pour la détection dudit signal d'entrée analogique, mais pour être utilisé à des fins de test et/ou de diagnostic, et l'autre circuit de détection de signaux analogiques hébergé (110, 120 ; 110', 120') est sélectionné pendant ledit intervalle de temps déterminé, pour être raccordé avec son premier système de raccordement à ladite entrée de signaux analogiques pour la détection dudit signal d'entrée analogique, et émettre sur son deuxième système de raccordement en tant que signal de sortie, en réaction au signal d'entrée analogique détecté, le signal de sortie du canal de détection de signaux analogique, et dans lequel le premier dispositif de sélection de liaison (115, 125) est prévu pour raccorder, en réaction à la sélection, le premier système de raccordement (111, 121) des deux circuits de détection de signaux analogiques (110, 120 ; 110', 120') hébergés, au moins soit à ladite entrée de signaux analogiques à raccorder, soit au circuit de diagnostic (130) pour la délivrance de signaux de test et de diagnostic.

2. Circuit d'entrée de signaux analogiques pour le traitement de signaux d'entrée analogiques pertinents pour la sécurité d'un processus, avec un premier nombre d'au moins deux canaux de détection de signaux analogiques (100 ; 100') pouvant être mis en service de manière redondante ou pouvant être accouplés pour former un bloc redondant, dans lequel :
- chaque canal de détection de signaux analogiques (100 ; 100') est prévu pour détecter des signaux d'entrée analogiques présents sur un deuxième nombre d'au moins deux entrées de signaux analogiques (201, 202 ; 201', 202') et émettre des signaux de sortie en réaction à des signaux d'entrée analogiques détectés ;
- chaque canal de détection de signaux analogiques (100 ; 100') héberge respectivement un troisième nombre de circuits de détection de signaux analogiques (110, 120 ; 110', 120'), au moins un circuit de diagnostic (130 ; 130') et au moins un premier dispositif de sélection de liaison (115, 125) ;
- dans lequel le troisième nombre est au moins de trois et est au plus supérieur de un au deuxième nombre ;
- chaque circuit de détection de signaux analogiques (110, 120 ; 110', 120') est pourvu d'un premier système de raccordement (111, 121) et d'un deuxième système de raccordement (112, 122) ;
- chacun des circuits de détection de signaux analogiques (110, 120 ; 110', 120') d'un canal de détection de signaux analogiques (100 ; 100') peut être relié avec son premier système de raccordement (111, 121) à respectivement une entrée de signaux analogiques parmi le deuxième nombre d'entrées de signaux analogiques (201, 202 ; 201', 202') pour la détection d'un signal d'entrée analogique, chacun des circuits de détection de signaux analogiques (110, 120 ; 110', 120') d'un canal de détection de signaux analogiques (100 ; 100') peut être relié au moins successivement dans le temps avec son premier système de raccordement (111, 121) à la même entrée de signaux analogiques parmi le deuxième nombre d'entrées de signaux analogiques (201, 202 ; 201', 202') pour la détection d'un signal d'entrée analogique, et tous les circuits du troisième nombre de circuits de détection de signaux analogiques (110, 120 ; 110', 120') d'un canal de détection de signaux analogiques (100 ; 100') sont prévus pour, en réaction à des signaux d'entrée analogiques détectés correspondant les uns aux autres, émettre des signaux de sortie correspondant les uns aux autres sur leurs deuxièmes systèmes de raccordement (112, 122) ;
- un circuit de détection de signaux analogiques est sélectionné en alternance pendant un intervalle de temps déterminable, par canal de détection de signaux analogiques (100 ; 100') pour la détection des signaux d'entrée analogiques présents sur des entrées de signaux analogiques parmi le deuxième nombre d'entrées de signaux analogiques et pour l'émission des signaux de sortie en réaction aux signaux d'entrée analogiques détectés, non pour être raccordé avec son premier système de raccordement à une entrée de signaux analogiques pour la détection d'un signal d'entrée analogique, mais pour être utilisé à des fins de test et/ou de diagnostic, et tous les autres circuits à l'exception dudit circuit du troisième nombre de circuits de détection de signaux analogiques hébergés (110, 120 ; 110', 120') sont sélectionnés pendant ledit intervalle de temps déterminé, pour être raccordés avec leurs premiers systèmes de raccordement à des entrées de signaux analogiques déterminées du deuxième nombre d'entrées de signaux analogiques pour la détection de signaux d'entrée analogiques, et émettre sur leurs deuxièmes systèmes de raccordement en tant que signaux de sortie, en réaction aux signaux d'entrée analogiques détectés, les signaux de sortie du canal de détection de signaux analogique, dans lequel le premier dispositif de sélection de liaison (115, 125) est prévu pour raccorder, en réaction à la sélection, les premiers systèmes de raccordement (111, 121) de tous les circuits de détection de signaux analogiques (110, 120 ; 110', 120') hébergés, au moins soit à une entrée de signaux analogiques déterminée à raccorder, soit au circuit de diagnostic (130) pour la délivrance de signaux de test et de diagnostic.

3. Circuit d'entrée de signaux analogiques selon la revendication 1 ou 2, dans lequel au moins un canal de détection de signaux analogiques (100, 100') est également prévu pour le traitement de signaux numériques et chaque circuit de détection de signaux analogiques (110, 120) dudit canal de détection de signaux analogiques héberge un convertisseur analogique/numérique (116, 126) dont la borne de signal numérique est connectée au deuxième système de raccordement (112, 122) et dont la borne de signal analogique est connectée vers le premier dispositif de sélection de liaison.

4. Circuit d'entrée de signaux analogiques selon l'une des revendications précédentes, dans lequel chaque canal de détection de signaux analogiques comprend un deuxième dispositif de sélection de liaison (101) prévu pour raccorder, en coordination avec le premier dispositif de sélection de liaison (115, 125), les deuxièmes systèmes de raccordement (112, 122) sélectionnés en conséquence à un dispositif de traitement (300) prévu pour le traitement consécutif des signaux de sortie du canal de détection de signaux analogiques ou au circuit de diagnostic (130).

5. Circuit d'entrée de signaux analogiques selon l'une des revendications précédentes, dans lequel le premier dispositif de sélection de liaison (115, 125) est prévu de manière à permettre la sélection d'un raccordement d'un premier système de raccordement (111, 112) respectif à l'entrée de signaux analogiques à raccorder, au circuit de diagnostic (130), avec au moins une tension de référence ou avec au moins une tension d'alimentation d'un dispositif périphérique.

6. Circuit d'entrée de signaux analogiques selon l'une des revendications précédentes, dans lequel le circuit de détection de signaux analogiques héberge un dispositif d'ajustement de signaux actif (114, 124).

7. Circuit d'entrée de signaux analogiques selon l'une des revendications précédentes, dans lequel un circuit de découplage (113, 123) est affecté au premier système de raccordement (111, 112).

8. Circuit d'entrée de signaux analogiques selon l'une des revendications précédentes, dans lequel au moins une entrée de signaux analogiques du deuxième nombre d'entrées de signaux analogiques (201, 202, 201', 202') comprend un circuit de protection d'entrée (221, 222) et/ou une unité d'ajustement de signaux passive (231, 232) en plus d'une borne d'entrée (211, 212).

9. Circuit d'entrée de signaux analogiques selon l'une des revendications précédentes, dans lequel le premier dispositif de sélection de liaison est réalisé comme unité de commutation analogique (115, 125), dans lequel une telle unité de commutation analogique est hébergée respectivement dans chaque circuit de détection de signaux analogiques (110, 120).
